# EUROPEAN PATENT APPLICATION

(11) **EP 2 466 576 A1**
(43) Date of publication of application: **20.06.2012**
(21) Application number: 11193543.3
(22) Date of filing: 14.12.2011
(51) Int. Cl.: G09G 3/30, H03M 1/78

(54) **Apparatus of driving light emitting diode using erasable programmable logic device chip**

(30) Priority: 15.12.2010 KR 20100128427
(71) Applicant: Samsung LED Co., Ltd., Yongi-city, Gyeonggi-Do 446-711 (KR)
(72) Inventor: Lee, Sang Hun, 443-470 Gyeonggi-do (KR); Lee, Chang Sub, 135-270 Seoul (KR); Kim, Ki Young, 420-834 Gyeonggi-do (KR); Kim, Min Su, 426-770 Gyeonggi-do (KR); Lee, Sang Gon, 130-101 Seoul (KR); Jung, Te O, 443-823 Gyeonggi-do (KR); Park, Jin Ho, 134-030 Seoul (KR)
(74) Representative: Grünecker, Kinkeldey, Stockmair & Schwanhäusser

(57) **Abstract**

Provided is an apparatus that drives a light emitting device using an erasable programmable logic device (EPLD) chip (310). The apparatus may include the light emitting device (220), and a driving unit to use the EPLD chip storing programming information corresponding to the light emitting device, and to drive the light emitting device based on the stored programming information. The EPLD chip may receive the programming information inputted from an external terminal, and may store the programming information in a predetermined storage space.

## Description

### CROSS-REFERENCE TO RELATED APPLICATION

This application claims the priority benefit of Korean Patent Application No. 10-2010-128427, filed on December 15, 2010, in the Korean Intellectual Property Office, the disclosure of which is incorporated herein by reference.

### BACKGROUND

### 1. Field

Example embodiments relate to a technology that embodies a driver for driving a light emitting device as an erasable programmable logic device (EPLD) chip and handles a change in the light emitting device without changing hardware.

### 2. Description of the Related Art

Recently, many countries have adopted the green growth model, for producing low carbon emissions, as as their industrial growth model.

Accordingly, the lighting field should accordingly adapt to the trend of the green growth model.

Electric energy consumed by lighting accounts for about 19 % of the total amount of electric energy consumed in the world and thus, when current lighting devices are replaced with high-efficiency lighting devices, about 70 % to 80 % of the current global energy consumption may be reduced.

In addition, a manufacturing cost of a light emitting diode (LED) has continuously decreased.

Therefore, an LED that reduces the energy consumption and the emission of carbon has drawn attention.

A driving voltage may be provided to drive a light emitting device, such as an LED, and a driver chip may be used to provide the driving voltage.

The driver chip may need to be changed to a driver chip that is appropriate for features of the changed light emitting device.

### SUMMARY

The foregoing and/or other aspects are achieved by providing a light emitting device driving apparatus, the apparatus including the light emitting device and a driving unit to use an erasable programming logic device (EPLD) chip storing programming information corresponding to the light emitting device, and to drive the light emitting device based on the stored programming information. Here, the EPLD chip may receive the programming information inputted from an external terminal, and may store the programming information in a predetermined storage space.

Additional aspects of embodiments will be set forth in part in the description which follows and, in part, will be apparent from the description, or may be learned by practice of the disclosure.

### EFFECT

According to example embodiments, even though a light emitting diode (LED) lamp is changed, the changed LED lamp may be operated without changing hardware.

According to example embodiments, simulation may show an output before performing porting to a hardware block and thus, debugging may be readily performed.

According to example embodiments, a program logic is checked, in advance, through simulation and thus, an LED driver chip optimized for the light emitting device may be designed.

According to example embodiments, a light emitting device may be operated using a single digital chip instead of using an existing LED driver chip.

### BRIEF DESCRIPTION OF THE DRAWINGS

These and/or other aspects will become apparent and more readily appreciated from the following description of embodiments, taken in conjunction with the accompanying drawings of which:
FIG. 1 illustrates an R-2R ladder type digital to analog (D/A) converter that drives a light emitting device;
FIG. 2 is a block diagram illustrating a light emitting device driving apparatus according to example embodiments;
FIG. 3 is a block diagram illustrating a driving unit according to example embodiments; and
FIG. 4 is a block diagram illustrating light emitting device driving apparatus according to example embodiment.

### DETAILED DESCRIPTION

Reference will now be made in detail to embodiments, examples of which are illustrated in the accompanying drawings, wherein like reference numerals refer to the like elements throughout. Embodiments are described below to explain the present disclosure by referring to the figures.

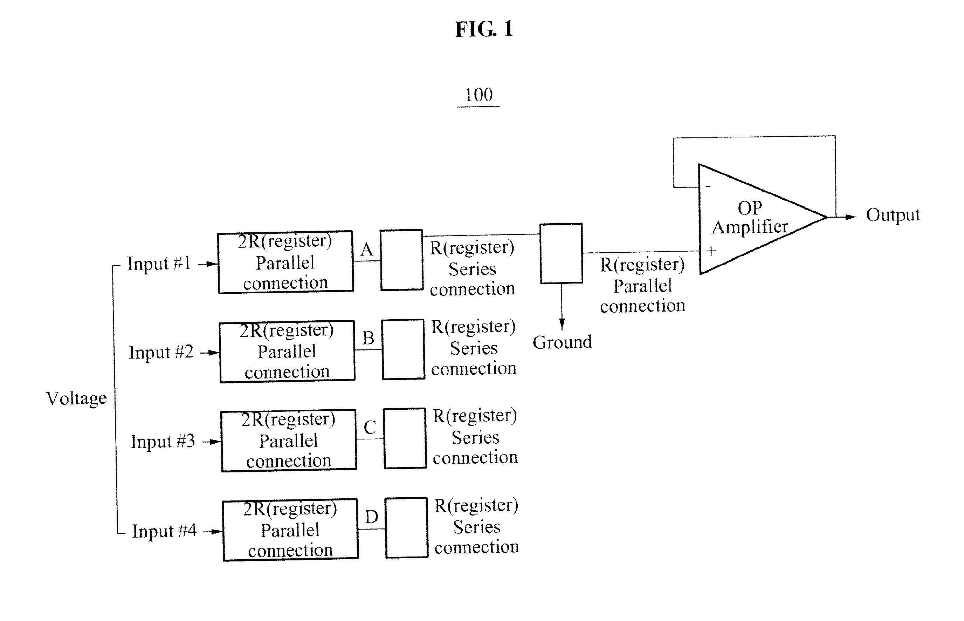

FIG. 1 illustrates an R-2R ladder type digital to analog (D/A) converter 100 that drives a light emitting device.

A light emitting device driving apparatus 100 may change a digital input into an analog output.

To change the digital input into the analog output, the light emitting device driving apparatus may perform a function of the R-2P ladder type D/A converter 100 of FIG. 1.

The light emitting device driving apparatus may store the function of the R-2R ladder type D/A converter 100 of FIG. 1 in an erasable programmable logic device (EPLD) chip, as programming information.

The R-2R ladder type D/A converter 100 of FIG. 1 may be configured as a ladder type using a resistance of R and a resistance of R2, the resistance of R2 being double the resistance of R.

In a ladder type circuit, an equivalent resistance value of 2R may occur at connection points A, B, C, and D of FIG. 1.

For example, when four-bit input of Input #1, Input #2, Input #3, and Input #4 are set as '0 0 1 0', an input of Input #3 is 1 and thus, a connection state at the connection point C may change. Since an input of Input #1 is zero, Input #1 may be determined as being grounded.

A resistor of resistance value 2R resistor is connected in parallel at the connection point A to a resistor of resistance value R and thus, may have an equivalent resistance value of R. W hen the circuit configuration is viewed from a point between the connection point B and the connection point A, the equivalent resistance R is connected in series and thus, may have an equivalent resistance value of 2R here.

In the same manner, Input #2 is zero and thus, Input #2 may be determined as being grounded. An equivalent resistor of equivalent resistance value 2R is connected in parallel at the connection point B and thus, may have an equivalent resistance value of R.

When the circuit configuration is viewed from a point between the connection point C and the connection point B, an equivalent resistor of equivalent resistance value R is connected in series and thus, may have an equivalent resistance value of 2R here.

In this example, Input #4 is zero, and thus, Input #4 may be determined as being grounded. Accordingly, a resistor of resistance value 2R resistor connected in parallel at the connection point D and thus, may have an equivalent resistance value of R.

When the circuit configuration is viewed from a point between the connection point C and the connection point D, an equivalent resistor of equivalent resistance value R is connected in series and thus, may have an equivalent resistance value of 2R.

Accordingly, when a voltage V is provided to Input #3, a current I of value V/3R may flow at the connection point C and the current may be divided into I/2 to the connection point C. Same principle may be applied to the connection points A, B, and D, in the same manner as at the connection point C.
The R-2R ladder type D/A may be programmed as below.
Project Name : MODULE LADDER
TITLE 'R-2R latter type D/A converter'
CLOCK, RST PIN 1,2; // DEFINE INPUT PIN
DA0..DA7 PIN 23,22,21,20,19,18,17,16 istype 'reg' // DEFINE OUTPUT PIN
SAR = [DA7..DA0] // DEFINE SET
EQUATIONS // EQUATION
SAR.CLK = CLOCK; // COUNTER CLOCK
SAR.SR = !RST; // DEFINE RESET
SAP := SAR + 1; // COUNTER INCREMENT
test_vectors
([CLOCK,RST] → [SAR]) // DEFINE INPUT/OUTPUT SIGNAL
[.c., 0] → [0];
@repeat 260{ // REPEAT 260 TIMES
[.c., 1] → [0];

The R-2R latter type D/A converter programmed as shown above may be ported to the EPLD chip of the light emitting device driving apparatus.

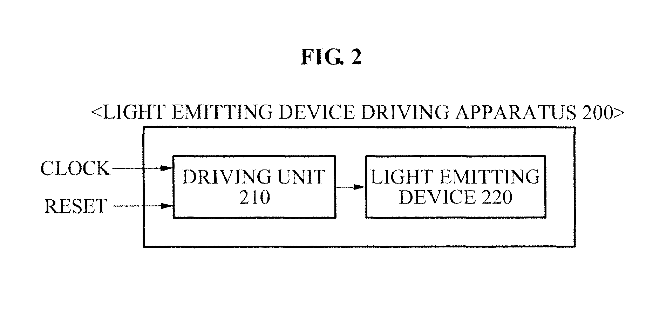

FIG. 2 illustrates a light emitting device driving apparatus 200 according to example embodiments

The light emitting device driving apparatus 200 may include a driving unit 210 and a light emitting device 220.

The driving unit 210 may perform a function of a driver chip for driving the light emitting device 220.

The driving unit 210 may use an EPLD chip storing programming information corresponding to the light emitting device 220, and may drive the light emitting device 220 based on the stored programming information.

The light emitting device 220 may include at least one light emitting diode (LED)

The EPLD in addition to a field programmable gate array (FPGA), a complex programmable logic device (CPLD), and a simple programmable logic device (SPLD) provide a different function based on inputted programming information.

Even though an LED lamp is changed, the light emitting device driving apparatus 200 may drive the changed LED lamp without changing hardware based on the features of the EPLD.

When the LED lamp is changed, programming information corresponding to the changed LED lamp is ported to the driving unit 210 and thus, the changed LED lamp may be operated.

The change in the LED lamp or a change in the light emitting device may indicate pulse width modulation (PWM), a change in an analog voltage provided to the LED lamp or the light emitting device, or a change of the light emitting device.

To port the programming information to the driving unit 210, the programming information may be received from an external terminal and may be stored in a predetermined storage space.

The EPLD chip of the driving unit 210 may output, based on the stored programming information, an analog type driving signal that drives the light emitting device 220, and the stored programming information may be updated by receiving an input from the external terminal. The programming information inputted from the external terminal may correspond to a feature of the changed light emitting device 220, and may be received from manufacturer of the light emitting device 220 or may be inputted by a manager.

The programming information including the feature of the light emitting device 220 may be stored in the EPLD, and thus, the EPLD may output the driving signal. In this example, a number of the driving signals outputted by the EPLD may be the same as a number of channels for load input of the light emitting device 220.

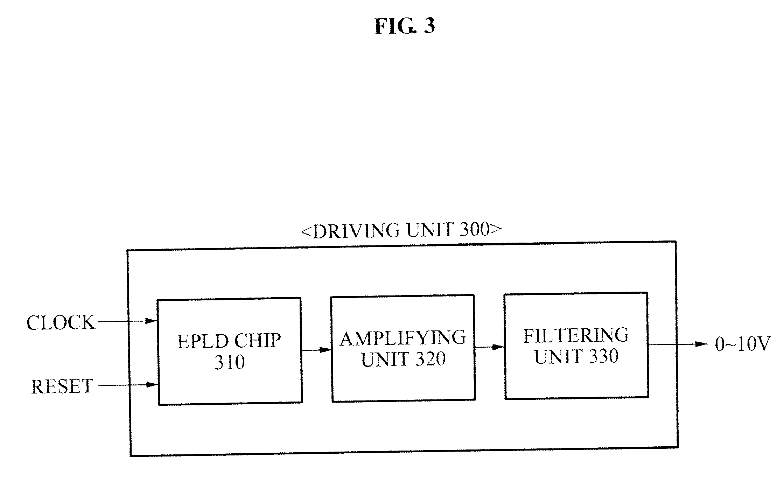

The driving unit 210 will be described with reference to FIG. 3.

FIG. 3 illustrates a driving unit 300 according to example embodiments.

The driving unit 300 may include an EPLD chip 310, an amplifying unit 320, and a filtering unit 330.

The EPLD chip 310 may include a function of a D/A converter, and may include programming information. The programming information may correspond to a feature of a light emitting device, and may drive the light emitting device.

When the light emitting device is replaced with a different light emitting device or there is a need to change a feature of the light emitting device, new programming information may be inputted from an external terminal and may be stored in a predetermined storage space.

To achieve the forgoing, the EPLE chip 310 may include an interface that may operate in conjunction with the external terminal, or may be electrically connected to the interface.

Referring to FIG. 3, the EPLD chip 310 may operate based on a clock signal and a reset signal.

The EPLD chip 310 may use the clock signal and the reset signal as an input, and may connect an output in parallel and thus, may drive a plurality of LED loads.

The amplifying unit 320 may amplify a driving signal outputted by the EPLD chip 310, based on the programming information ported in the EPLD chip 310.

Since a function of the D/A converter is ported in the EPLD chip 310, the driving signal may be outputted as an analog type.

The driving signal may be a voltage, and the amplifying unit 320 may amplify the voltage to a predetermined level.

The amplifying unit 320 may include at least one field effect transistor (FET).

The amplifying unit 320 may amplify the driving signal based on the at least one FET.

The filtering unit 330 may perform low-band filtering with respect to the amplified driving signal.

The filtering unit 330 may include a noise filter that removes noise from the driving signal to perform low-band filtering, and may include an operational amplifier (OP Amp) that amplifies the low-band filtered driving signal.

A resistance/capacitance (RC) filter may be used as the noise filter.

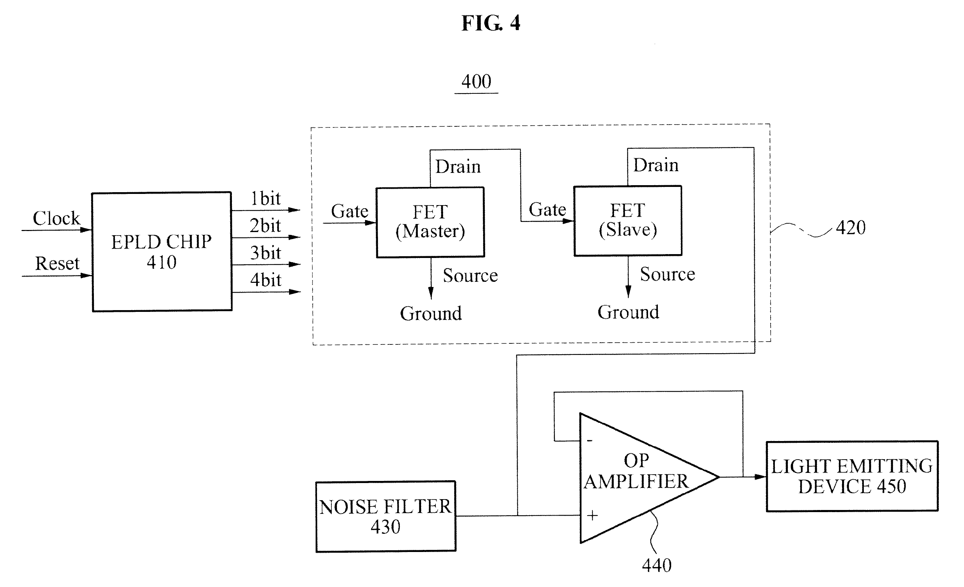

FIG. 4 illustrates a light emitting device driving apparatus 400 according to example embodiments.

The light emitting device driving apparatus 400 may output a voltage in a range of 0 to 10 V to drive a light emitting device 450, in response to a digital input of a reset signal or a clock signal.

The light emitting device driving apparatus 400 may include an EPLD chip 410 that outputs an analog type driving signal, based on the digital input of the reset signal or the clock signal.

The output of the EPLD chip 410 may be transferred to the amplifying unit 420. The amplifying unit 420 may include at least one FET.

For example, the amplifying unit 420 may include a master FET that performs a master function and a slave FET that performs a slave function.

An analog voltage that is primarily generated from an output port of the EPLD chip 410 may be a driving signal.

An accuracy of the driving signal passing through the master FET may increase.

The analog voltage may be generated by inputting, to an OP amplifier 440, an output outputted via a drain port of the slave FET, after inputting the driving signal outputted from a drain port of the master FET to a gate port of the slave FET.

The light emitting device driving apparatus 400 may input an output from the EPLD chip 410 to at least one FET and an OP Amp, and may perform dimming control with respect to light emitting device 450.

In this example, since the output from the EPLD chip 410 is affected by low frequency, a ripple occurring in a signal may be removed by adding a noise filter 430, for example, an R/C filter.

A block including amplifying unit 420, the noise filter 430, and the OP Amp 440, may be added, a number of the added blocks being equal to a number of outputs of the EPLD chip 410, to increase a number of output channels.

An output may be measured with a circuit configured as a passive device, an output may be measured with a circuit configured as the EPLD chip, and the output measured with the circuit configured as the passive device and the output measured with the circuit configured as the EPLD chip may be compared to each other and thus, verification is performed.

The light emitting device driving apparatus 400 may perform coding of the D/A converter configured as a PLD and porting the PLD to the EPLD chip 410, and may operate the light emitting device based on an output signal.

According to an embodiment, even though an LED lamp is changed, the LED lamp may be operated without changing hardware.

According to an embodiment, simulation may show the output before performing porting to a hardware block and thus, debugging may be readily performed.

According to an example embodiment, a program logic may be checked, in advance, through the simulation and thus, an LED driver chip optimized for the light emitting device may be designed.

According to an example embodiment, the light emitting device may be operated using a single digital chip instead of using an existing LED driver chip.

The method according to the above-described embodiments may be recorded in non-transitory computer-readable media including program instructions to implement various operations embodied by a computer. The media may also include, alone or in combination with the program instructions, data files, data structures, and the like. Examples of non-transitory computer-readable media include magnetic media such as hard disks, floppy disks, and magnetic tape; optical media such as CD ROM discs and DVDs; magneto-optical media such as optical discs; and hardware devices that are specially configured to store and perform program instructions, such as read-only memory (ROM), random access memory (RAM), flash memory, and the like. Examples of program instructions include both machine code, such as produced by a compiler, and files containing higher level code that may be executed by the computer using an interpreter. The described hardware devices may be configured to act as one or more software modules in order to perform the operations of the above-described embodiments, or vice versa.

Although embodiments have been shown and described, it would be appreciated by those skilled in the art that changes may be made in these embodiments without departing from the principles and spirit of the disclosure, the scope of which is defined by the claims and their equivalents.

## Claims

1. An apparatus for driving a light emitting device, the apparatus comprising:
the light emitting device; and
a driving unit to use an erasable programming logic device (EPLD) chip storing programming information corresponding to the light emitting device, and to drive the light emitting device based on the stored programming information,
wherein the EPLD chip receives the programming information inputted from an external terminal, and stores the programming information in a predetermined storage space.

2. The apparatus of claim 1, wherein the EPLD chip outputs an analog type driving signal that drives the light emitting device based on the stored programming information.

3. The apparatus of claim 2, wherein a number of the driving signals outputted by the EPLD chip is equal to a number of channels for load input of the light emitting device.

4. The apparatus of claim 2, wherein the driving unit comprises:
an amplifying unit to amplify the driving signal; and
a filtering unit to remove noise from the amplified driving signal.

5. The apparatus of claim 4, wherein the amplifying unit amplifies the driving signal based on at least one field effect transistor (FET).

6. The apparatus of claim 4, wherein the filtering unit comprises:
a noise filter to perform low-band filtering by removing noise of the driving signal;
and
an operational (OP) amplifier to amplify the driving signal from which noise is removed.

7. The apparatus of claim 1, wherein the light emitting device comprises at least one light emitting diode (LED).

8. The apparatus of claim 1, wherein the program information processes a function of a digital analog converter (DAC) embodied as a programmable logic device (PLD).

9. The apparatus of claim 2, wherein a number of the driving signals outputted by the EPLD chip is equal to a number of channels for load input of the light emitting device.
